# EUROPEAN PATENT SPECIFICATION

(11) **EP 4 397 429 B1**
(45) Date of publication and mention of the grant of the patent: **11.11.2026**
(21) Application number: 22876377.7
(22) Date of filing: 28.09.2022
(51) Int. Cl.: B23K 26/00, H01S 5/068, H01S 5/042, H01S 5/062, H01S 5/02251

(54) **LASER PROCESSING APPARATUS**
LASERBEARBEITUNGSVORRICHTUNG
APPAREIL DE TRAITEMENT LASER

(30) Priority: 30.09.2021 JP 2021161433
(43) Date of publication of application: 10.07.2024
(73) Proprietor: Hamamatsu Photonics K.K., Hamamatsu-shi, Shizuoka 435-8558 (JP)
(72) Inventor: KUNO Koji, Hamamatsu-shi, Shizuoka 435-8558 (JP)
(74) Representative: Grünecker Patent- und Rechtsanwälte PartG mbB
(86) International application number: PCT/JP2022/036259
(87) International publication number: WO 2023/054511

(56) References cited:
- CN-U- 211 305 195
- JP-A- 2000 215 772
- JP-A- 2000 307 174
- JP-A- 2005 095 934
- JP-A- 2012 070 055
- JP-A- 2018 147 951
- JP-A- 2019 136 733
- JP-A- 2019 187 187
- US-A1- 2020 365 345

## Description

### Technical Field

The present disclosure relates to a laser processing apparatus.

### Background Art

Patent Literature 1 describes an interlock circuit including relays connected in series between a DC power supply and a load, and a control switch that drives the relays. In the interlock circuit, semiconductor switches are connected in series between the DC power supply and the relays, and a delay drive circuit is connected to the semiconductor switches, so that the welding of relay contacts due to an inrush current is prevented.

### Citation List

### Patent Literature

Patent Literature 1: Japanese Unexamined Patent Publication No. 2000-215772

### Summary of Invention

### Technical Problem

By the way, in a laser processing apparatus used for the laser processing of an object as well, an interlock function is introduced to prevent a worker from being exposed to a laser light, for example, when a protection housing is opened to carry in and out the object. As such an interlock function, as one example, it can be considered that a mechanical shutter for shutting off the laser light is provided inside a laser irradiation unit that irradiates the object with the laser light from a laser light source.

However, when a transmission optical fiber connected to the laser irradiation unit is used as an optical transmission path between the laser light source and the laser irradiation unit, the transmission optical fiber is deemed to be an optical delivery system, so that providing a mechanical shutter at the front stage of the transmission optical fiber, namely, inside the laser light source is required (providing a shutter device at an entrance of the optical delivery system is required). However, since it is difficult to provide the mechanical shutter inside the laser light source, in the case of fiber transmission, another interlock function needs to be examined.

As another interlock function in the laser processing apparatus using the transmission optical fiber, for example, it can be considered that instead of a mechanical shutter, an interlock circuit described in Patent Literature 1 is provided in a power supply of the laser light source to shut off the power supply. However, in the case of a laser processing apparatus with a high processing throughput, for example, since a protection housing is frequently opened and closed due to the carry-in and carry-out of an object, the interlock circuit needs to be frequently operated. Therefore, when a mechanical relay is used as the interlock circuit described above, frequent replacements are required due to the lifespan thereof, which is not desirable.

Therefore, an object of the present disclosure is to provide a laser processing apparatus having a long-lifespan and highly reliable interlock function.

### Solution to Problem

A laser processing apparatus according to the present disclosure includes: a laser light source configured to oscillate a laser light; a transmission optical fiber configured to transmit the oscillated laser light from the laser light source; a laser irradiation unit configured to irradiate an object with the laser light transmitted by the transmission optical fiber; a power supply configured to receive an input of an AC voltage to generate a drive voltage for enabling the laser light source to oscillate the laser light, and to apply the drive voltage to the laser light source; a semiconductor switch provided on a path of the drive voltage between the power supply and the laser light source; a mechanical relay provided on an AC path that is a path of the AC voltage to the power supply; and a control unit configured to monitor a control signal including an ON signal for setting the semiconductor switch to an ON state and an OFF signal for setting the semiconductor switch to an OFF state to shut off the signal path. The control unit monitors an output voltage of the semiconductor switch, and when it is determined that there is an abnormality in the semiconductor switch by comparing the control signal with the output voltage, the control unit shuts off the path of the AC voltage by setting the mechanical relay to an OFF state.

The laser processing apparatus transmits the laser light from the laser light source to the laser irradiation unit using the transmission optical fiber. Therefore, a method for shutting off the power supply of the laser light source is employed as an interlock function. Particularly, in the laser processing apparatus, the semiconductor switch is provided on the path of the voltage supply between the power supply and the laser light source, and by setting the semiconductor switch to an OFF state, the path of the voltage supply (namely, power supply) is shut off, and the laser oscillation of the laser light source is stopped. Generally, the semiconductor switch has a longer lifespan than the mechanical relay. Therefore, accordingly, a long-lifespan interlock function is realized. On the other hand, the mechanical relay is provided on the supply path of the AC voltage that is the source of the voltage supply in the power supply. In the event of an abnormality in the semiconductor switch, the control unit shuts off the AC voltage to the power supply by setting the mechanical relay to an OFF state. Therefore, even when an abnormality occurs in the semiconductor switch, the voltage supply from the power supply to the laser light source is prevented, and the interlock function is maintained. Therefore, reliability is improved. Incidentally, the laser processing apparatus also employs the mechanical relay; however, the mechanical relay operates only when an abnormality occurs in the semiconductor switch having a long-lifespan, and the frequency of operations is very small. Therefore, the influence of the lifespan of the mechanical relay on the lifespan of the interlock function is very small. As described above, the laser processing apparatus has a long-lifespan and highly reliable interlock function.

The laser processing apparatus according to the present disclosure may include a first semiconductor switch and a second semiconductor switch as the semiconductor switch provided in series between the power supply and the laser light source. When both the control signals to the first semiconductor switch and the second semiconductor switch are the OFF signals, and it is detected that both the first semiconductor switch and the second semiconductor switch are in an ON state, based on output voltages of the first semiconductor switch and the second semiconductor switch, the control unit may determine that there is an abnormality in the first semiconductor switch and the second semiconductor switch, and may set the mechanical relay to an OFF state. In this case, when one of the two semiconductor switches connected in series is normal, the interlock function functions effectively. In addition, since the mechanical relay operates only when an abnormality occurs in both the two semiconductor switches, the frequency of operations of the mechanical relay is further reduced. Therefore, an even longer lifespan is achieved, and reliability is further improved.

The laser processing apparatus according to the present disclosure may include a first mechanical relay and a second mechanical relay provided in series on the power path as the mechanical relay. When it is determined that there is an abnormality in the semiconductor switch, the control unit may set both the first mechanical relay and the second mechanical relay to an OFF state. In this case, reliability can be further improved.

In the laser processing apparatus according to the present disclosure, the control unit may transmit a power supply OFF signal for turning off the power supply to the power supply when the OFF signal is output to the semiconductor switch, and may transmit a power supply ON signal for turning on the power supply to the power supply after the ON signal is output to the semiconductor switch. The power supply may include a slow start circuit, and when the power supply receives the power supply ON signal from the control unit, the slow start circuit may cause a voltage value of the drive voltage to gradually increase. In this case, the generation of an inrush current when the power supply is turned on is suppressed, and the occurrence of a malfunction such as the blowing out of a fuse of the laser light source is suppressed. Therefore, a long-lifespan is reliably achieved.

### Advantageous Effects of Invention

According to the present disclosure, it is possible to provide the laser processing apparatus having a long-lifespan and highly reliable interlock function.

### Brief Description of Drawings

FIG. 1 is a schematic diagram showing a laser processing apparatus according to the present embodiment.
FIG. 2 is a diagram showing one example of a logic circuit inside a safety controller.
FIG. 3 is a table showing a list of input and output combinations of the logic circuit shown in FIG. 2.
FIG. 4 is a graph for describing an inrush current.

### Description of Embodiments

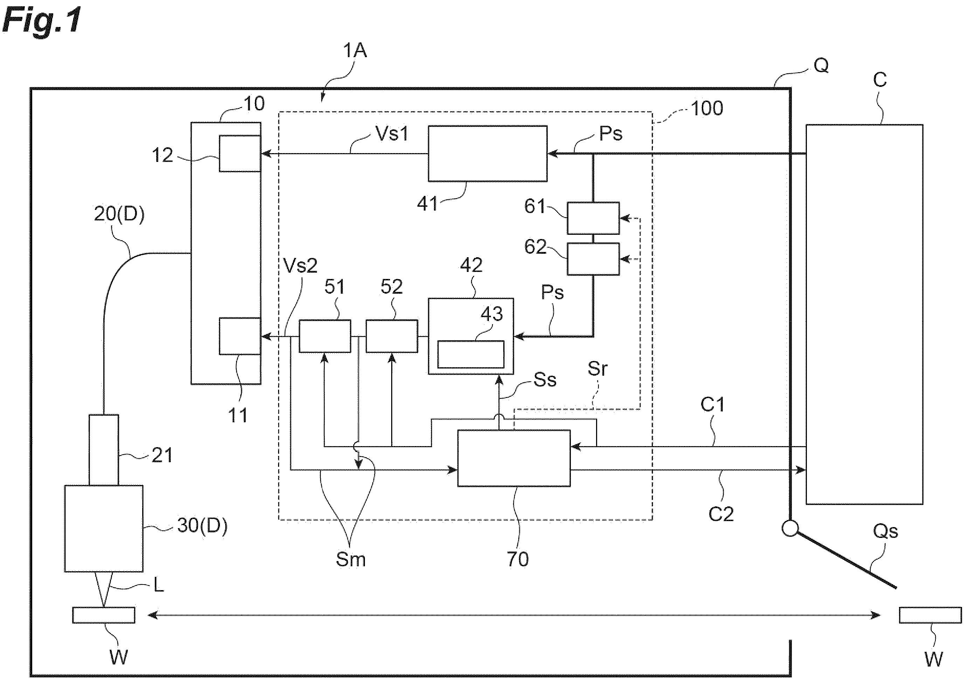

Hereinafter, one embodiment of the present disclosure will be described with reference to the drawings. FIG. 1 is a schematic diagram showing a laser processing apparatus according to the present embodiment. As shown in FIG. 1, a laser processing apparatus 1A is an apparatus that processes an object W, and is accommodated in a protection housing Q. The laser processing apparatus 1A includes a laser main body (laser light source) 10, a transmission optical fiber 20, a laser optical unit (laser irradiation unit) 30, and a power supply unit 100. The laser main body 10 is a laser light source that includes, for example, a laser element such as a laser diode, and that oscillates a laser light L.

The laser main body 10 includes a laser power supply 11 and a control power supply 12 thereinside. The control power supply 12 supplies power to a circuit that controls conditions related to laser oscillation (for example, laser output, frequency, pulse width, the start and stop of laser oscillation, and the like) commanded from external apparatus C. In the laser main body 10, a drive voltage Vs2 (for example, DC 24 V) from the power supply unit 100 is input to the laser power supply 11, and a laser drive circuit of the laser main body 10 enters an oscillation state, so that the laser light L can be oscillated.

The transmission optical fiber 20 is optically connected to the laser main body 10 at one end thereof, and is optically connected to the laser optical unit 30 via a laser output unit 21 at the other end thereof. The transmission optical fiber 20 transmits the laser light L output from the laser main body 10.

The laser optical unit 30 is a laser irradiation unit that can be disposed to face the object W to be laser-processed, and that irradiates the object W with the laser light L transmitted by the transmission optical fiber 20. For this purpose, for example, the laser optical unit 30 may include various optical elements such as a condenser lens that condenses the laser light L toward the object W. The transmission optical fiber 20 and the laser optical unit 30 constitute an optical delivery system D. Therefore, the entrance of the optical delivery system D is the entrance of the transmission optical fiber 20.

The power supply unit 100 includes a first power supply 41 and a second power supply (power supply) 42. The external apparatus C is connected to input sides (primary sides) of the first power supply 41 and the second power supply 42. The first power supply 41 receives an input of an AC voltage Ps (for example, AC 200 V) from the external apparatus C to generate a DC voltage Vs1 (for example, DC 24 V). The first power supply 41 applies the DC voltage Vs1 to the control power supply 12 of the laser main body 10. The second power supply 42 receives an input of the AC voltage Ps (for example, AC 200 V) from the external apparatus C to generate the DC drive voltage Vs2 (for example, DC 24 V). The second power supply 42 applies the drive voltage Vs2 for enabling the laser main body 10 to oscillate the laser light to the laser power supply 11 of the laser main body 10. Incidentally, the second power supply 42 includes a slow start circuit 43.

The power supply unit 100 includes a first semiconductor switch (semiconductor switch) 51 and a second semiconductor switch (semiconductor switch) 52 provided between the second power supply 42 and the laser main body 10 on an output side (secondary side) of the second power supply 42. The first semiconductor switch 51 and the second semiconductor switch 52 are configured as, for example, semiconductor relays (solid state relay: SSR). The first semiconductor switch 51 and the second semiconductor switch 52 are connected in series in order from a laser main body 10 side on a path of the drive voltage Vs2. Therefore, by setting at least one of the first semiconductor switch 51 and the second semiconductor switch 52 to an OFF state, the path of the drive voltage Vs2 toward the laser main body 10 can be shut off. In this case, in the laser processing apparatus 1A, the oscillation of the laser light L in the laser main body 10 is stopped.

The power supply unit 100 includes a first mechanical relay 61 and a second mechanical relay 62 provided on the input side (primary side) of the second power supply 42. The first mechanical relay 61 and the second mechanical relay 62 are on a path of the AC voltage Ps from the external apparatus C toward the second power supply 42, and are connected in series in order from a branch point of the path of the AC voltage Ps, which travels from the external apparatus C toward the first power supply 41, toward the second power supply 42. Therefore, by operating at least one of the first mechanical relay 61 and the second mechanical relay 62, the path of the AC voltage Ps to the second power supply 42 can be shut off while maintaining the path of the AC voltage Ps to the first power supply 41. In this case, in the laser processing apparatus 1A, the oscillation of the laser light L in the laser main body 10 is stopped.

The power supply unit 100 includes a safety controller (control unit) 70. As the safety controller 70, a circuit certified as a safety circuit can be used. The safety controller 70 monitors a control signal C1 including an oscillation stop command transmitted from the external apparatus C to each of the first semiconductor switch 51 and the second semiconductor switch 52. The control signal C1 includes an ON signal for setting each of the first semiconductor switch 51 and the second semiconductor switch 52 to an ON state, and an OFF signal for setting each of the first semiconductor switch 51 and the second semiconductor switch 52 to an OFF state to shut off the path of the drive voltage Vs2.

In addition, the safety controller 70 transmits a control signal Sr for setting each of the first mechanical relay 61 and the second mechanical relay 62 to an OFF state to each of the first mechanical relay 61 and the second mechanical relay 62. In addition, the safety controller 70 transmits a control signal Ss including a power supply ON signal for turning on the second power supply 42 and a power supply OFF signal for turning off the second power supply 42 to the second power supply 42.

On the other hand, the safety controller 70 receives a monitor signal Sm for monitoring an output voltage of each of the first semiconductor switch 51 and the second semiconductor switch 52. Accordingly, the safety controller 70 can monitor the output voltages of the first semiconductor switch 51 and the second semiconductor switch 52.

Furthermore, the safety controller 70 transmits and receives signals to and from the external apparatus C. More specifically, the safety controller 70 receives the control signal C1 including an oscillation stop command of the laser light L from the external apparatus C, and transmits a signal C2 including an oscillation stop report of the laser light L, a failure of the first semiconductor switch 51 and the second semiconductor switch 52, a disconnection of a signal line, or a failure of the safety controller 70 to the external apparatus C. The signal C2 is configured by a plurality of signal lines, but is represented by a single line for simplicity of description. The control signal C1 is transmitted to the safety controller 70, for example, when a door Qs of the protection housing Q is opened to carry the object W into the protection housing Q. Since a control signal line of the control signal C1 is an important signal line related to the safety function, the control signal C1 is configured by two or more electric wires. When one of the electric wires is disconnected, the states of two signal lines become different from each other, so that the safety controller 70 can detect the disconnection of the control signal line by detecting this state. The safety controller 70 transmits the signal C2 as an oscillation stop report to the external apparatus C in response to receiving the control signal C1 when the first semiconductor switch 51 and the second semiconductor switch 52 are set to an OFF state to shut off the path of the drive voltage Vs2 and the oscillation of the laser light L is stopped. Since the oscillation stop report in the signal C2 is an important function related to the safety function, the oscillation stop report is configured by two or more electric wires. When one of the electric wires is disconnected, the states of two signal lines become different from each other, so that a controller on an external apparatus C side can detect the disconnection of the control signal line by detecting this state.

As described above, in the laser processing apparatus 1A, first, the external apparatus C transmits the control signal C1 related to the oscillation stop command to each of the first semiconductor switch 51 and the second semiconductor switch 52. The safety controller 70 receives (monitors) the control signal C1.

Subsequently, the safety controller 70 monitors the output voltages of the first semiconductor switch 51 and the second semiconductor switch 52 by receiving the monitor signal Sm, and transmits the signal C2 related to the oscillation stop report to the external apparatus C when it is determined that the output voltages are, for example, 0 V and the first semiconductor switch 51 and the second semiconductor switch 52 are in an OFF state. The external apparatus C opens the door Qs of the protection housing Q in response to receiving the signal C2. As described above, in the laser processing apparatus 1A, when the safety controller 70 detects that the first semiconductor switch 51 and the second semiconductor switch 52 operate normally and the oscillation of the laser light L is stopped, the door Qs of the protection housing Q can be safely opened.

Here, the laser processing apparatus 1A detects a failure of the first semiconductor switch 51 and the second semiconductor switch 52, and has a function of stopping the oscillation of the laser light L even in the event of a failure of the first semiconductor switch 51 and the second semiconductor switch 52.

Namely, in the laser processing apparatus 1A, the safety controller 70 monitors the output voltages of the first semiconductor switch 51 and the second semiconductor switch 52, and determines the presence or absence of an abnormality in the first semiconductor switch 51 and the second semiconductor switch 52 by comparing the control signal C1 to the first semiconductor switch 51 and the second semiconductor switch 52 with the output voltages.

Then, when it is determined that there is an abnormality in the first semiconductor switch 51 and the second semiconductor switch 52, the safety controller 70 transmits the control signal Sr for setting each of the first mechanical relay 61 and the second mechanical relay 62 to an OFF state to each of the first mechanical relay 61 and the second mechanical relay 62. Accordingly, the safety controller 70 shuts off the path of the AC voltage Ps to the second power supply 42 by setting the first mechanical relay 61 and the second mechanical relay 62 to an OFF state. As a result, the oscillation of the laser light L is stopped, and safety is ensured.

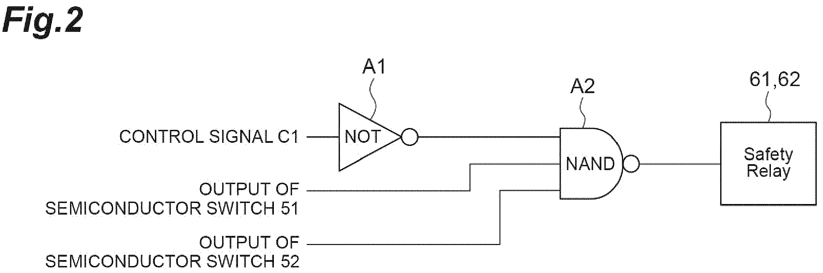

FIG. 2 is a diagram showing one example of a logic circuit inside the safety controller. As shown in FIG. 2, in the safety controller 70, the control signal C1 to the first semiconductor switch 51 and the second semiconductor switch 52 is input to a NAND circuit A2 via a NOT circuit A1, and an output of each of the first semiconductor switch 51 and the second semiconductor switch 52 is input to the NAND circuit A2. The outputs of the first semiconductor switch 51 and the second semiconductor switch 52 can be detected by the monitor signal Sm. Then, an output of the NAND circuit A2 is input to the first mechanical relay 61 and the second mechanical relay 62.

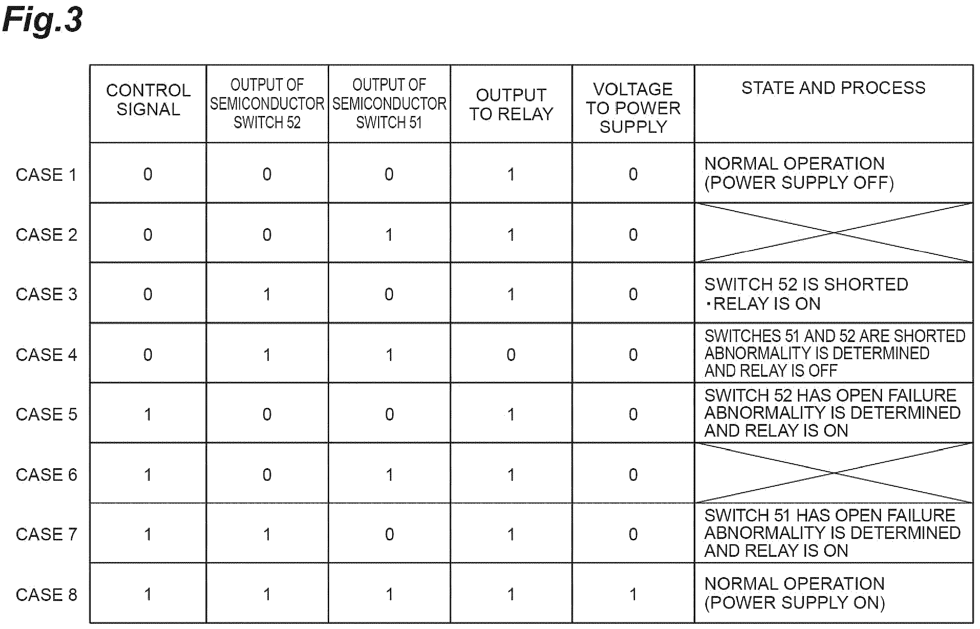

FIG. 3 is a table showing a list of input and output combinations of the logic circuit shown in FIG. 2. In FIG. 3, the control signal C1 is set to "0" when the first semiconductor switch 51 and the second semiconductor switch 52 are set to an OFF state to stop the oscillation of the laser light L, and the control signal C1 is set to "1" when the first semiconductor switch 51 and the second semiconductor switch 52 are set to an ON state to oscillate the laser light L. For example, the outputs of the first semiconductor switch 51 and the second semiconductor switch 52 are set to "0" in the case of 0 V, and are set to "1" in the case of 24 V. Furthermore, the first mechanical relay 61 and the second mechanical relay 62 are set to an ON state in the case of "1", and are set to an OFF state in the case "0", so that the path of the AC voltage Ps is shut off.

As shown in Case 4 of FIG. 3, in the safety controller 70, when the control signal C1 is "0" and the outputs of the first semiconductor switch 51 and the second semiconductor switch 52 are "1", it is determined that there is an abnormality (short circuit) in both the first semiconductor switch 51 and the second semiconductor switch 52. Therefore, in Case 4, the first mechanical relay 61 and the second mechanical relay 62 are set to an OFF state ("0"), and as a result, the drive voltage Vs2 to the laser power supply 11 is shut off (set to "0"). In this case, the safety controller 70 outputs a fail output, which indicates that the first semiconductor switch 51 and the second semiconductor switch 52 have a short circuit failure, to the signal line of the signal C2.

Other cases are as shown in the table. Namely, in Case 1, since the control signal C1 is "0" and the outputs of both the first semiconductor switch 51 and the second semiconductor switch 52 are also "0", both the first semiconductor switch 51 and the second semiconductor switch 52 are normal, so that the first mechanical relay and the second mechanical relay 62 are maintained in the ON state ("1"). In this case, the safety controller 70 outputs a signal indicating the oscillation stop report to the signal line of the signal C2.

In addition, in Case 3, the control signal C1 is "0" and the output of the first semiconductor switch 51 is "0", but the output of the second semiconductor switch 52 is "1", so that a short circuit is recognized only in the second semiconductor switch 52. However, since the first semiconductor switch 51 operates normally and the shut-off of the drive voltage Vs2 is realized, the first mechanical relay and the second mechanical relay 62 are maintained in the ON state ("1"). In this case, the safety controller 70 does not output a fail output, which indicates that the second semiconductor switch 52 has a short circuit failure, to the signal line of the signal C2, and also does not output the oscillation stop report of the laser light L. Since the oscillation stop signal is not output, an operational abnormality can be detected on the external apparatus C side. Incidentally, in Case 2, since the output of the second semiconductor switch 52 on the further upstream side (second power supply 42 side) is "0", the output of the first semiconductor switch 51 on the further downstream side does not become "1", which is an impossible situation.

In addition, in Case 5, the control signal C1 is "1", but the outputs of both the first semiconductor switch 51 and the second semiconductor switch 52 are "0", so that an open failure of at least the second semiconductor switch 52 is recognized. In this case, since the drive voltage Vs2 to the laser power supply 11 is shut off as a result, a malfunction where the oscillation of the laser light L is unintentionally stopped occurs, but no safety problem occurs, so that the first mechanical relay 61 and the second mechanical relay 62 are maintained in the ON state ("1"). In this case, since a fail output indicating that the second semiconductor switch 52 or the like has an open failure is output to the signal line of the signal C2, an operational abnormality can be detected on the external apparatus C side.

In Case 7, the control signal C1 is "1" and the output of the second semiconductor switch 52 is "1", but the output of the first semiconductor switch 51 is "0", so that an open failure is recognized only in the first semiconductor switch 51. In this case as well, since the drive voltage Vs2 to the laser power supply 11 is shut off as a result, a malfunction where the oscillation of the laser light L is unintentionally stopped occurs, but no safety problem occurs, so that the first mechanical relay 61 and the second mechanical relay 62 are maintained in the ON state ("1"). In this case, the safety controller 70 outputs a fail output, which indicates that the first semiconductor switch 51 has an open failure, to the signal line of the signal C2. Incidentally, in Case 6, since the output of the second semiconductor switch 52 on the further upstream side (second power supply 42 side) is "0", the output of the first semiconductor switch 51 on the further downstream side does not become "1", which is an impossible situation.

Furthermore, in Case 8, since the control signal C1 is "1", the outputs of the first semiconductor switch 51 and the second semiconductor switch 52 are "1", and a normal operation is recognized, the first mechanical relay 61 and the second mechanical relay 62 are maintained in the ON state ("1").

As described above, when both the control signals C1 to the first semiconductor switch 51 and the second semiconductor switch 52 are OFF signals, and it is detected that both the first semiconductor switch 51 and the second semiconductor switch 52 are in an ON state, the safety controller 70 determines that there is an abnormality in the first semiconductor switch 51 and the second semiconductor switch 52, and sets the first mechanical relay 61 and the second mechanical relay 62 to an OFF state.

Incidentally, as shown in FIG. 1, when the control signal C1 that is an OFF signal is transmitted to the first semiconductor switch 51 and the second semiconductor switch 52 to stop the oscillation of the laser light L, the safety controller 70 can transmit the control signal (power supply OFF signal) Ss for turning off the second power supply 42 in conjunction therewith. Accordingly, the first semiconductor switch 51 and the second semiconductor switch 52 are set to an OFF state, and the second power supply 42 is also turned off, so that the output becomes 0 (for example, attenuated by 50% in 400 mS).

In addition, after the control signal C1 that is an ON signal is transmitted to the first semiconductor switch 51 and the second semiconductor switch 52 to start the oscillation of the laser light L (for example, after 100 ms), the safety controller 70 can transmit the control signal (power supply ON signal) Ss for turning on the second power supply 42.

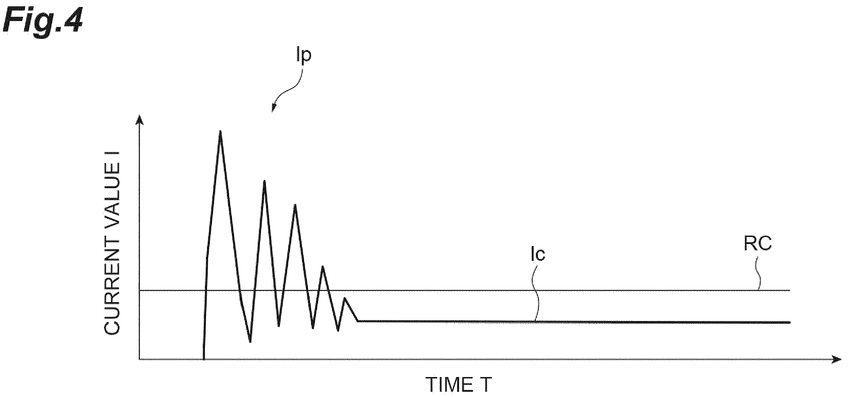

Here, the laser main body 10 is provided with a fuse (not shown). Generally, in many cases, a capacitor is provided at an input stage of the power supply unit such that the output current or voltage does not fluctuate greatly even when there are fluctuations on a load side. In a case where a capacitor is provided at the input stage, the capacitor needs to be charged when power is applied to the power supply unit, whereby as shown in FIG. 4, a current larger than a fuse rated current RC flows until a steady current Ic is reached. This current is an inrush current Ip. The lifespan at which the fuse blows out is defined by a product I²T of the square of the current value of the instantaneous inrush current Ip and the pulse width of the current, and the number n of power supply inrushes (I²t-T characteristic). In a case where the power supply is turned on approximately once a day, the fuse does not blow out in a short time; however, in a case where the frequency of power supply inrushes is increased, this will no longer be the case.

On the other hand, the second power supply 42 includes the slow start circuit 43 as described above. Therefore, when the second power supply 42 receives the control signal Ss from the safety controller 70 to turn on, the slow start circuit 43 prevents a rapid increase in the voltage value of the drive voltage Vs2, and causes the voltage value to gradually increase. Accordingly, the generation of inrush current Ip is suppressed, and the fuse is prevented from blowing out.

As described above, the laser processing apparatus 1A transmits the laser light L from the laser main body 10 to the laser optical unit 30 using the transmission optical fiber 20. Therefore, a method for shutting off the power supply of the laser main body 10 is employed as an interlock function. Particularly, in the laser processing apparatus 1A, the semiconductor switches (the first semiconductor switch 51 and the second semiconductor switch 52) are provided on the path of the drive voltage Vs2 between the second power supply 42 and the laser main body 10, and by setting the semiconductor switches to an OFF state, the path of the drive voltage Vs2 (namely, power supply) is shut off, and the laser oscillation of the laser main body 10 is stopped. At the same time, the safety controller 70 monitors the output voltages of the semiconductor switches.

Generally, the semiconductor switch has a longer lifespan than the mechanical relay. Therefore, accordingly, a long-lifespan interlock function is realized. On the other hand, the mechanical relays (the first mechanical relay 61 and the second mechanical relay 62) are provided on the supply path of the AC voltage Ps that is the source of the drive voltage Vs2 in the second power supply 42. In the event of an abnormality in the semiconductor switches, the safety controller 70 shuts off the AC voltage Ps to the second power supply 42 by setting the mechanical relays to an OFF state.

Therefore, even when an abnormality occurs in the semiconductor switches, the drive voltage Vs2 from the second power supply 42 is prevented from being applied to the laser main body 10, and the interlock function is maintained. Therefore, reliability is improved. Incidentally, the laser processing apparatus 1A also employs the mechanical relays; however, the mechanical relays operate only when an abnormality occurs in the semiconductor switches having a long-lifespan, and the frequency of operations is very small. Therefore, the influence of the lifespan of the mechanical relay on the lifespan of the interlock function is very small. As described above, the laser processing apparatus 1A has a long-lifespan and highly reliable interlock function.

In addition, the laser processing apparatus 1A includes the first semiconductor switch 51 and the second semiconductor switch 52 as semiconductor switches provided in series between the second power supply 42 and the laser main body 10. When both the control signals C1 to the first semiconductor switch 51 and the second semiconductor switch 52 are OFF signals, and it is detected that both the first semiconductor switch 51 and the second semiconductor switch 52 are in an ON state, based on the output voltages of the first semiconductor switch 51 and the second semiconductor switch 52, the safety controller 70 determines that there is an abnormality in the first semiconductor switch 51 and the second semiconductor switch 52, and sets the mechanical relays to an OFF state.

For this reason, when one of the first semiconductor switch 51 and the second semiconductor switch 52 connected in series is normal, the interlock function functions effectively. Since the mechanical relays operate only when an abnormality occurs in both the first semiconductor switch 51 and the second semiconductor switch 52, the frequency of operations of the mechanical relays is further reduced. Therefore, an even longer lifespan is achieved, and reliability is further improved.

In addition, the laser processing apparatus 1A includes the first mechanical relay 61 and the second mechanical relay 62, which are provided in series on the path of the AC voltage Ps to the second power supply 42, as mechanical relays. When it is determined that there is an abnormality in the semiconductor switches, the safety controller 70 sets both the first mechanical relay 61 and the second mechanical relay 62 to an OFF state. For this reason, reliability can be further improved.

Furthermore, in the laser processing apparatus 1A, the safety controller 70 transmits the power supply OFF signal (control signal Ss) for turning off the second power supply 42 to the second power supply 42 when the OFF signal is output to the semiconductor switches, and transmits the power supply ON signal (control signal Ss) for turning on the second power supply 42 to the second power supply 42 after the ON signal is output to the semiconductor switches. The second power supply 42 includes the slow start circuit 43, and when the second power supply 42 receives the power supply ON signal from the safety controller 70, the slow start circuit 43 causes the voltage value of the drive voltage Vs2 to gradually increase. For this reason, the generation of the inrush current Ip when the second power supply 42 is turned on is suppressed, and the occurrence of a malfunction such as the blowing out of the fuse of the laser main body 10 is suppressed. Therefore, a long-lifespan is reliably achieved.

The above embodiment has described one aspect of the laser processing apparatus 1A according to the present disclosure. Therefore, the laser processing apparatus 1A according to the present disclosure can be optionally modified.

For example, in the embodiment, the example in which the laser processing apparatus 1A includes the first semiconductor switch 51 and the second semiconductor switch 52 connected in series to each other on the path of the drive voltage Vs2 between the second power supply 42 and the laser main body 10 has been described. However, the number of the semiconductor switches included in the laser processing apparatus 1A is not limited to 2, and may be 1 or 3 or more.

Similarly, in the embodiment, an example in which the laser processing apparatus 1A includes the first mechanical relay 61 and the second mechanical relay 62 connected in series to each other on the path of the AC voltage Ps to the second power supply 42 has been described; however, the number of the mechanical relays included in the laser processing apparatus 1A is not limited to 2, and may 1 or 3 or more.

Furthermore, as in Case 3 or Case 7 of FIG. 3, when an abnormality (a short circuit or an open failure) is detected in one of the first semiconductor switch 51 and the second semiconductor switch 52, the safety controller 70 may set at least one of the first mechanical relay 61 and the second mechanical relay 62 to an OFF state. Namely, when it is determined that there is an abnormality in at least one of a plurality of the semiconductor switches, the safety controller 70 may set at least one of a plurality of the mechanical relays to an OFF state. Furthermore, the safety controller 70 in the power supply unit 100 may be omitted, and a safety controller (not shown) of the external apparatus C may have the function of the safety controller 70.

### Industrial Applicability

The laser processing apparatus having a long-lifespan and highly reliable interlock function is provided.

### Reference Signs List

1A: laser processing apparatus, 10: laser main body (laser light source), 11: laser power supply, 12: control power supply, 20: transmission optical fiber, 21: laser output unit, 30: laser optical unit (laser irradiation unit), 41: first power supply, 42: second power supply (power supply), 43: slow start circuit, 51: first semiconductor switch (semiconductor switch), 52: second semiconductor switch (semiconductor switch), 61: first mechanical relay (mechanical relay), 62: second mechanical relay (mechanical relay), 70: safety controller (control unit), 100: power supply unit, A1: NOT circuit, A2: NAND circuit, C: external apparatus, C1: control signal, C2: signal, L: laser light, Ps: AC voltage, Q: protection housing, Qs: door, Sm: monitor signal, Sr: control signal, Ss: control signal, Vs1: DC voltage, Vs2: drive voltage, W: object, Ic: steady current, Ip: inrush current, RC: fuse rated current.

## Claims

1. A laser processing apparatus comprising:
a laser light source configured to oscillate a laser light;
a transmission optical fiber configured to transmit the oscillated laser light from the laser light source;
a laser irradiation unit configured to irradiate an object with the laser light transmitted by the transmission optical fiber;
a power supply configured to receive an input of an AC voltage to generate a drive voltage for enabling the laser light source to oscillate the laser light, and to apply the drive voltage to the laser light source;
a semiconductor switch provided on a path of the drive voltage between the power supply and the laser light source;
a mechanical relay provided on a path of the AC voltage to the power supply; and
a control unit configured to monitor a control signal including an ON signal for setting the semiconductor switch to an ON state and an OFF signal for setting the semiconductor switch to an OFF state to shut off the path of the drive voltage,
wherein the control unit is configured to monitor an output voltage of the semiconductor switch, and is configured to determine that there is an abnormality in the semiconductor switch by comparing the control signal with the output voltage, the control unit is further configured to shut off the path of the AC voltage by setting the mechanical relay to an OFF state.

2. The laser processing apparatus according to claim 1, comprising:
a first semiconductor switch and a second semiconductor switch as the semiconductor switch provided in series between the power supply and the laser light source,
wherein, when both the control signals to the first semiconductor switch and the second semiconductor switch are the OFF signals, and it is detected that both the first semiconductor switch and the second semiconductor switch are in an ON state, based on output voltages of the first semiconductor switch and the second semiconductor switch, the control unit is configured to determine that there is an abnormality in the first semiconductor switch and the second semiconductor switch, and is configured to set the mechanical relay to an OFF state.

3. The laser processing apparatus according to claim 1 or 2, comprising:
a first mechanical relay and a second mechanical relay provided in series on the path of the AC voltage as the mechanical relay,
wherein, when it is determined that there is an abnormality in the semiconductor switch, the control unit is configured to set both the first mechanical relay and the second mechanical relay to an OFF state.

4. The laser processing apparatus according to any one of claims 1 to 3,
wherein the control unit is configured to transmit a power supply OFF signal for turning off the power supply to the power supply when the OFF signal is output to the semiconductor switch, and configured to transmit a power supply ON signal for turning on the power supply to the power supply after the ON signal is output to the semiconductor switch, and
the power supply includes a slow start circuit, and when the power supply receives the power supply ON signal from the control unit, the slow start circuit causes a voltage value of the drive voltage to gradually increase.

## Patentansprüche

1. Laserbearbeitungsvorrichtung, umfassend:
eine Laserlichtquelle, die dazu eingerichtet ist, Laserlicht zum Oszillieren zu bringen;
eine Übertragungslichtleitfaser, die dazu eingerichtet ist, das oszillierte Laserlicht von der Laserlichtquelle zu übertragen;
eine Laserbestrahlungseinheit, die dazu eingerichtet ist, ein Objekt mit dem durch die Übertragungslichtleitfaser übertragenen Laserlicht zu bestrahlen;
eine Stromversorgung, die dazu eingerichtet ist, eine Wechselspannung als Eingang zu empfangen, um eine Ansteuerspannung zum Ermöglichen des Oszillierens des Laserlichts durch die Laserlichtquelle zu erzeugen, und die Ansteuerspannung an die Laserlichtquelle anzulegen;
einen Halbleiterschalter, der auf einem Pfad der Ansteuerspannung zwischen der Stromversorgung und der Laserlichtquelle vorgesehen ist;
ein mechanisches Relais, das auf einem Pfad der Wechselspannung zu der Stromversorgung vorgesehen ist; und
eine Steuereinheit, die dazu eingerichtet ist, ein Steuersignal zu überwachen, das ein EIN-Signal zum Versetzen des Halbleiterschalters in einen EIN-Zustand und ein AUS-Signal zum Versetzen des Halbleiterschalters in einen AUS-Zustand umfasst, um den Pfad der Ansteuerspannung zu unterbrechen,
wobei die Steuereinheit dazu eingerichtet ist, eine Ausgangsspannung des Halbleiterschalters zu überwachen, und dazu eingerichtet ist, durch Vergleichen des Steuersignals mit der Ausgangsspannung festzustellen, dass eine Anomalie in dem Halbleiterschalter vorliegt, wobei die Steuereinheit ferner dazu eingerichtet ist, den Pfad der Wechselspannung durch Versetzen des mechanischen Relais in einen AUS-Zustand zu unterbrechen.

2. Laserbearbeitungsvorrichtung nach Anspruch 1, umfassend:
einen ersten Halbleiterschalter und einen zweiten Halbleiterschalter als den Halbleiterschalter, die in Reihe zwischen der Stromversorgung und der Laserlichtquelle vorgesehen sind,
wobei, wenn sowohl die Steuersignale zu dem ersten Halbleiterschalter als auch zu dem zweiten Halbleiterschalter die AUS-Signale sind und auf Grundlage von Ausgangsspannungen des ersten Halbleiterschalters und des zweiten Halbleiterschalters erkannt wird, dass sich sowohl der erste Halbleiterschalter als auch der zweite Halbleiterschalter in einem EIN-Zustand befinden, die Steuereinheit dazu eingerichtet ist, festzustellen, dass eine Anomalie in dem ersten Halbleiterschalter und dem zweiten Halbleiterschalter vorliegt, und dazu eingerichtet ist, das mechanische Relais in einen AUS-Zustand zu versetzen.

3. Laserbearbeitungsvorrichtung nach Anspruch 1 oder 2, umfassend:
ein erstes mechanisches Relais und ein zweites mechanisches Relais, die als das mechanische Relais in Reihe auf dem Pfad der Wechselspannung vorgesehen sind,
wobei, wenn festgestellt wird, dass eine Anomalie in dem Halbleiterschalter vorliegt, die Steuereinheit dazu eingerichtet ist, sowohl das erste mechanische Relais als auch das zweite mechanische Relais in einen AUS-Zustand zu versetzen.

4. Laserbearbeitungsvorrichtung nach einem der Ansprüche 1 bis 3,
wobei die Steuereinheit dazu eingerichtet ist, ein Stromversorgungs-AUS-Signal zum Abschalten der Stromversorgung an die Stromversorgung zu übertragen, wenn das AUS-Signal an den Halbleiterschalter ausgegeben wird, und dazu eingerichtet ist, ein Stromversorgungs-EIN-Signal zum Einschalten der Stromversorgung an die Stromversorgung zu übertragen, nachdem das EIN-Signal an den Halbleiterschalter ausgegeben wird, und
die Stromversorgung eine Sanftanlaufschaltung umfasst, und, wenn die Stromversorgung das Stromversorgungs-EIN-Signal von der Steuereinheit empfängt, die Sanftanlaufschaltung bewirkt, dass sich ein Spannungswert der Ansteuerspannung allmählich erhöht.

## Revendications

1. Appareil de traitement laser comprenant :
une source de lumière laser configurée pour faire osciller une lumière laser ;
une fibre optique de transmission configurée pour transmettre la lumière laser oscillée provenant de la source de lumière laser ;
une unité d'irradiation laser configurée pour irradier un objet avec la lumière laser transmise par la fibre optique de transmission ;
une alimentation électrique configurée pour recevoir en entrée une tension alternative afin de générer une tension de commande permettant à la source de lumière laser de faire osciller la lumière laser, et pour appliquer la tension de commande à la source de lumière laser ;
un commutateur à semi-conducteur disposé sur un trajet de la tension de commande entre l'alimentation électrique et la source de lumière laser ;
un relais mécanique disposé sur un trajet de la tension alternative vers l'alimentation électrique ; et
une unité de commande configurée pour surveiller un signal de commande comprenant un signal de mise en marche destiné à mettre le commutateur à semi-conducteur dans un état passant et un signal d'arrêt destiné à mettre le commutateur à semi-conducteur dans un état bloqué afin de couper le trajet de la tension de commande,
dans lequel l'unité de commande est configurée pour surveiller une tension de sortie du commutateur à semi-conducteur, et est configurée pour déterminer qu'une anomalie est présente dans le commutateur à semi-conducteur en comparant le signal de commande à la tension de sortie, l'unité de commande étant en outre configurée pour couper le trajet de la tension alternative en mettant le relais mécanique dans un état bloqué.

2. Appareil de traitement laser selon la revendication 1, comprenant :
un premier commutateur à semi-conducteur et un second commutateur à semi-conducteur en tant que commutateur à semi-conducteur, disposés en série entre l'alimentation électrique et la source de lumière laser,
dans lequel, lorsque les deux signaux de commande destinés au premier commutateur à semi-conducteur et au second commutateur à semi-conducteur sont les signaux d'arrêt, et qu'il est détecté que le premier commutateur à semi-conducteur et le second commutateur à semi-conducteur sont tous deux dans un état passant, sur la base de tensions de sortie du premier commutateur à semi-conducteur et du second commutateur à semi-conducteur, l'unité de commande est configurée pour déterminer qu'une anomalie est présente dans le premier commutateur à semi-conducteur et le second commutateur à semi-conducteur, et est configurée pour mettre le relais mécanique dans un état bloqué.

3. Appareil de traitement laser selon la revendication 1 ou 2, comprenant :
un premier relais mécanique et un second relais mécanique disposés en série sur le trajet de la tension alternative en tant que relais mécanique,
dans lequel, lorsqu'il est déterminé qu'une anomalie est présente dans le commutateur à semi-conducteur, l'unité de commande est configurée pour mettre à la fois le premier relais mécanique et le second relais mécanique dans un état bloqué.

4. Appareil de traitement laser selon l'une quelconque des revendications 1 à 3,
dans lequel l'unité de commande est configurée pour transmettre un signal d'arrêt de l'alimentation électrique destiné à arrêter l'alimentation électrique à l'alimentation électrique lorsque le signal d'arrêt est délivré au commutateur à semi-conducteur, et est configurée pour transmettre un signal de mise en marche de l'alimentation électrique destiné à mettre en marche l'alimentation électrique à l'alimentation électrique après que le signal de mise en marche a été délivré au commutateur à semi-conducteur, et
l'alimentation électrique comprend un circuit de démarrage progressif, et, lorsque l'alimentation électrique reçoit le signal de mise en marche de l'alimentation électrique provenant de l'unité de commande, le circuit de démarrage progressif amène une valeur de tension de la tension de commande à augmenter progressivement.
